# EUROPEAN PATENT APPLICATION

(11) **EP 2 525 416 A2**
(43) Date of publication of application: **21.11.2012**
(21) Application number: 12168073.0
(22) Date of filing: 15.05.2012
(51) Int. Cl.: H01L 31/061, C23C 16/26, H01L 21/3065, H01L 21/311, H01L 21/67

(54) **Method for rear point contact fabrication for solar cells**

(30) Priority: 17.05.2011 US 201161487243 P
(71) Applicant: Intevac, Inc., Santa Clara, CA 95054 (US)
(72) Inventor: Cho, Young Kyu, San Jose, CA California 95120 (US); Huang, Judy, Los Gatos, CA California 95030 (US)
(74) Representative: Kirschner, Klaus Dieter

(57) **Abstract**

A method for forming holes in the backside dielectric layer of solar cells for fabrication of rear point contact is disclosed wherein the backside dielectric layer is coated with a layer of carbon. A shadow mask is placed over the carbon layer and reactive ion etch (RIE) is used to transfer the holes in the shadow mask to the carbon layer, to thereby form a carbon mask. The shadow mask is then removed and RIE is used to transfer the holes from the carbon mask to the dielectric layer. The carbon mask is then removed by, e.g., ashing.

## Description

The invention refers to a method for fabrication of solar cells and, more specifically for forming holes for fabrication of rear point contact of solar cells.

Various designs of solar cells have electrical contacts formed in the rear surface, the rear surface meaning the solar cell surface that does not face the sun. One example of rear point contact solar cell is provided in US-A-4,927,770.

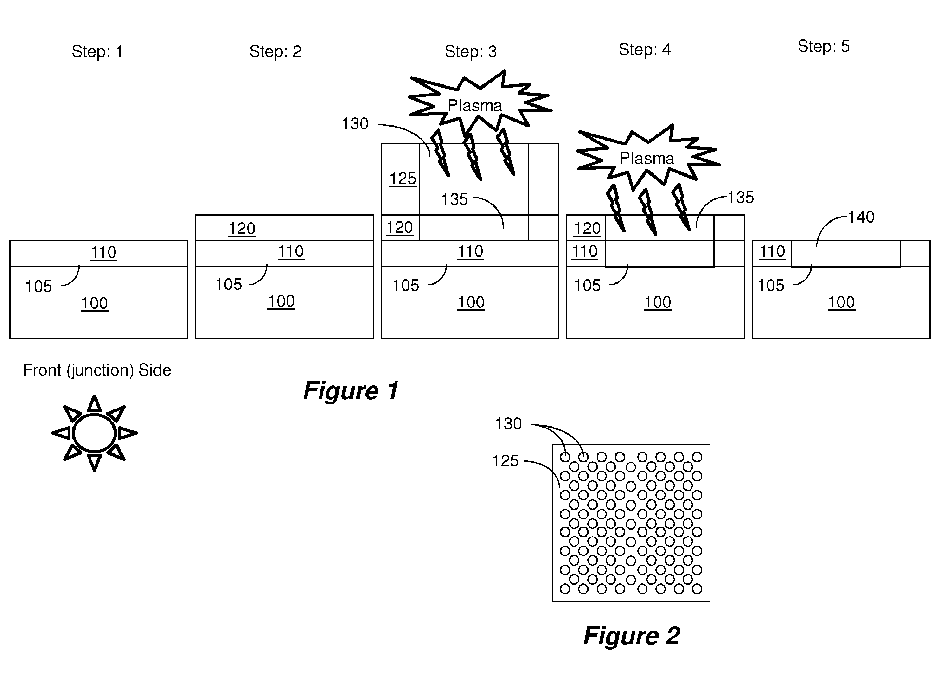

As shown in Swanson's Figure 2B, openings need to be made in the two passivation layers; however, Swanson does not disclose how these openings can be made.

The rear point contact structure is also used in high efficiency cells normally referred to as PERL (passivated emitter and rear locally diffused) and PERC (passivated emitter and rear cell). In solar cells employing rear point contact, the back surface is passivated using, e.g., silicon oxide, or silicon nitride or both. The point contacts have to be made through these passivation layers. The proper size and pitch of the rear point contact affects the efficiency, and it is, therefore, important to have a process for consistently and accurately making the contact holes in the passivation layers.

According to some prior art methods, the holes in the passivation layers are made using wet etching procedure. However, dry processes are preferred over wet processes. Therefore, one candidate for replacing the wet etch process for making rear point contact is plasma etch.

Accordingly, there's a need for making holes for rear point contact structure in a consistent and repeatable manner, using dry processes.

The following summary is included in order to provide a basic understanding of some aspects and features of the disclosure. This summary is not an extensive overview of the invention and as such it is not intended to particularly identify key or critical elements of the invention or to delineate the scope of the invention. Its sole purpose is to present some concepts of the invention in a simplified form as a prelude to the more detailed description that is presented below.

Aspects of the invention provide a method which ensures consistent and precise formation of holes in the rear side of a solar cell, so that rear point contacts can be made.

According to aspects of the invention, a removable carbon film is deposited over the dielectric layer on the back (rear) side of the solar cell. Then, a shadow mask is used to define holes in the carbon layer, such that the carbon layer functions as a removable mask. The shadow mask is then removed, and the carbon removable mask is used to form the holes in the dielectric layer. Thereafter, the carbon mask is removed.

According to one embodiment, a system is provided for forming holes in backside of solar cells, for fabrication of rear point contact. The system includes a carbon deposition chamber, a showdown mask mechanical placement chamber, a carbon etch chamber, a shadow mask mechanical removal chamber, and a dielectric etch chamber. The dielectric etch chamber may be used as carbon ashing or, alternatively, the system may include a separate carbon ashing chamber.

Other aspects and features of the invention would be apparent from the detailed description, which is made with reference to the following drawings. It should be appreciated that the detailed description and the drawings provides various non-limiting examples of various embodiments of the invention, which is defined by the appended claims.

The accompanying drawings, which are incorporated in and constitute a part of this specification, exemplify various embodiments and, together with the description, serve to explain and illustrate principles of the invention. The drawings are intended to illustrate major features of the exemplary embodiments in a diagrammatic manner. The drawings are not intended to depict every feature of actual embodiments nor relative dimensions of the depicted elements and are, therefore, not drawn to scale.

Further advantages, features and potential applications of the present invention may be gathered from the description which follows, in conjunction with the embodiments illustrated in the drawings.

Throughout the description, the claims and the drawings, those terms and associated reference signs will be used as are notable from the enclosed list of reference signs. In the drawings
- Fig. 1: illustrates a process for forming the holes of rear point contact, according to one embodiment;
- Fig. 2: is an illustration of a shadow mask, according to one embodiment, and
- Fig. 3: illustrates a system for forming the holes for rear point contact in solar cells, according to one embodiment.

A description will now be provided of various embodiments which enable consistent and precise formation of holes for rear point contact in solar cells. The method may be used for various type of solar cells, such as PERL, PERC, etc. To provide a concrete example, some of the discussion that follows refers to a solar cell having two dielectric layers formed on the backside thereof, wherein the rear point contact needs to be formed through both dielectric layers.

According to the following disclosed embodiment, a solar cell has a p-n junction formed on the front side thereof, and two dielectric layers formed on the backside thereof. This is illustrated in Figure 1, wherein the solar cell is fabricated using a substrate 100, and forming a first dielectric layer 105 which functions as a passivation layer, and a second dielectric layer 110 over the first dielectric layer. Of course, only a single dielectric layer or more than two dielectric layers can be formed and the method would work just as well. As schematically illustrated in Figure 1, the front side of the solar cell is for facing the sun, while the back or rear side is for facing away from the sun.

One idea for making the holes in the backside is to place a shadow mask over the backside and use plasma to etch the holes through the mask. A shadow mask is generally a plate made of materials such as silicon, ceramic, graphite, silicon carbide, etc., which is placed over the solar cell. That is, as opposed to photoresist and other types of masks that are deposited or formed directly on the substrate, a shadow mask is a physical element separate from the substrate, which is mechanically placed over the substrate during use, and thereafter can then be mechanically removed. Plasma etching through the holes in the shadow mask can be used to form the holes in the substrate in certain process condition that requires very low bias level. However, usually etching the dielectric layer requires high energy ions which generate large amount of heat on the shadow mask. As the shadow mask heats up, it expands, such that the pattern of the holes drifts during the etching process.

To avoid drift of the mask pattern during etching, a two-step masking process is utilized. A shadow mask is used to form aligned holes in a carbon mask. Then the shadow mask is removed and the holes are etched in the dielectric layer through the carbon mask. Since etching the carbon layer does not require high ion energy nor generate a lot of heat (unlike dielectric etch), the holes from the shadow mask are transferred to the carbon mask without drift. In case of the carbon mask, it is deposited over the dielectric layer, and it expands together with the dielectric, so that no drift occurs.

As shown in Figure 1, in step 2 a layer 120 of carbon film is deposited over the back side of the solar cell. The carbon film can be deposited by using, e.g., chemical vapor deposition (CVD), physical vapor deposition (PVD), etc. In one embodiment, the carbon layer is deposited using CVD by heating a gas mixture comprising one or more hydrocarbon compounds and an inert gas to thermally decompose the hydrocarbon compounds in the gas mixture to form an amorphous carbon layer. Suitable hydrocarbon compounds include gases having the general formula CxHy, wherein x has a range of 2 to 4 and y has a range of 2 to 10. The gas mixture may be heated to a temperature between about 100° to about 700° C.

With further reference to Figure 1, in step 3 a shadow mask 125 is placed over the back of the solar cell and the solar cell with the shadow mask are placed inside a plasma etch chamber. An example of a shadow mask is shown in Figure 2. The mask 125 is substantially a thin plate with holes 130 formed in it in places where the rear point contacts should be made when the mask is aligned to the solar cell. The mask can be made of materials such as silicon, ceramic, graphite, silicon carbide, etc. The mask may be of the same size and shape as the solar cell, or may be larger than the solar cell to enable easier handling.

Plasma is used to etch the carbon layer through the holes 130 in the shadow mask, so as to form corresponding holes 135 in the carbon layer. In one embodiment, the carbon layer may be etched using plasma of hydrogen bromide (HBr), oxygen (O₂), and argon (Ar). This step forms a carbon hard mask. The shadow mask is then removed, and in step 4, plasma is ignited to etch holes 140 in the dielectric layers 105 and 110, through the holes 135 in the carbon hard mask. Etching the dielectric layer may be done using plasma suitable for etching the dielectric material. For example, plasma of CxFy (C2F6, CF4, C4F8 etc), O2 and N2 can be used to etch dielectrics of silicon nitride and silicon oxide.

In step 5 the carbon hard mask is removed. The carbon hard mask layer may be removed by exposure to an oxygen containing plasma in the same or different processing chamber for etching the holes 140. In another embodiment, the carbon hard mask layer may be removed using plasma formed from hydrogen bromide and oxygen. Alternatively, plasma formed from hydrogen (H₂) or a mixture of oxygen and a diluent gas such as argon (Ar) may be used to remove the carbon hard mask layer.

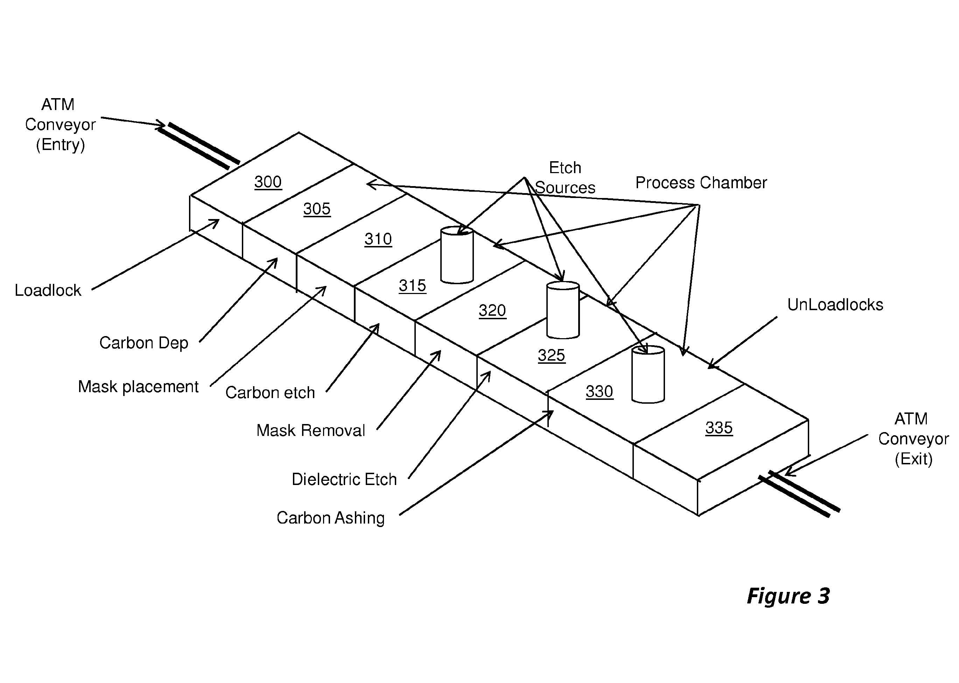

Figure 3 illustrates a system for forming the holes for rear point contact in solar cells, according to one embodiment. In one example, each chamber of the system of Figure 3 can process several solar cells simultaneously. A conveyor delivers solar cells into the system. The solar cells are delivered such that they are facing down, i.e., the surface of the cells that is meant to face the sun, is facing down on the conveyor. The cells enter a load lock chamber 300 wherein the cells are introduced into the vacuum environment of the system. The cells are then transferred to processing chamber 305, wherein a carbon layer is deposited on the backside of the cells. Chamber 305 may be, for example, a CVD chamber. The cells are then transferred to chamber 310, wherein a shadow mask is mechanically placed over the cells. The cells are then transferred into processing chamber 315, wherein plasma is sustained to etch the carbon layer through the holes in the shadow mask. The cells are then transferred to chamber 320, wherein the shadow mask is mechanically removed from the cells. The cells are then transferred into processing chamber 325, wherein the dielectric layers are etched through the holes in the carbon layer. The carbon layer is then removed in processing chamber 330. Alternatively, the carbon layer can be removed in situ in chamber 325. The cells are then transferred to loadlock 335 to be unloaded onto the conveyor.

As can be understood from the above description, the holes for rear point contact are fabricated using dual-mask arrangement. A shadow mask is used to form holes in a carbon layer to thereby create a removable carbon mask. The holes in the dielectric layers are etched through the carbon mask, so that the alignment of the holes is not drifted due to thermal expansion.

While the invention has been described with reference to particular embodiments thereof, it is not limited to those embodiments. Specifically, various variations and modifications may be implemented by those of ordinary skill in the art without departing from the invention's scope, as defined by the appended claims.

### List of reference signs

- 100: substrate
- 105: first dielectric layer
- 110: second dielectric layer
- 120: layer
- 125: mask
- 130: holes
- 135: holes
- 140: holes
- 300: chamber
- 305: chamber
- 310: chamber
- 315: chamber
- 320: chamber
- 325: chamber
- 330: chamber
- 335: chamber

## Claims

1. A method for forming holes in backside dielectric layer of solar cells for fabrication of rear point contact, comprising:
delivering solar cell having dielectric layer on the backside into a vacuum processing system;
depositing a layer of carbon over the dielectric layer;
mechanically placing a shadow mask over the carbon layer, the shadow mask having a plurality of holes aligned for the rear point contact locations;
generating plasma so as to etch the carbon layer through the plurality of holes in the shadow mask;
mechanically removing the shadow mask from the solar cell;
generating plasma so as to etch the dielectric layer through the carbon layer; and,
removing the carbon layer.

2. The method of claim 1, wherein removing the carbon layer comprises ashing the carbon layer using plasma.

3. The method of claim 2, wherein the step of ashing the carbon layer is performed in-situ in same chamber used for etching the dielectric layer.

4. The method of claim 2, wherein ashing is performed in oxygen gas.

5. The method of claim 1, wherein placing the shadow mask comprise placing a substantially flat plate having a plurality of holes on the backside of the solar cell.

6. The method of claim 5, wherein the flat plate is made of silicon, ceramic, graphite, or silicon carbide.

7. The method of claim 1, wherein depositing a layer of carbon comprises decomposing a hydrocarbon gas in a chemical vapor deposition chamber.

8. The method of claim 7, wherein the hydrocarbon gas comprises CxHy, wherein x has a range of 2 to 4 and y has a range of 2 to 10.

9. The method of claim 7, wherein decomposing a hydrocarbon gas comprises heating a hydrocarbon gas to between 100°C to 700°C.

10. The method of claim 1, wherein generating plasma so as to etch the carbon layer comprises generating plasma using a mixture of hydrogen bromide, oxygen and argon.

11. A system for etching holes in backside of solar cells for rear point contact, comprising:
a loadlock for introducing solar cells into vacuum environment;
a carbon deposition chamber for depositing carbon layer over the backside of the solar cells;
a mask loading chamber for mechanically placing a shadow mask over the solar cells;
a carbon etch chamber for etching holes in the carbon layer through the shadow mask;
a dielectric etch chamber for etching holes in dielectric layer of the solar cells, through the carbon layer;
a mask unloading chamber for mechanically removing the shadow mask from the solar cells; and,
an unloadlock for removing solar cells from vacuum environment.

12. The system of claim 11, further comprising a carbon ashing chamber for removing the carbon layer after etching holes in the dielectric layer.

13. The system of claim 11, wherein the carbon deposition chamber comprises a chemical vapor deposition chamber.

14. The system of claim 13, wherein the chemical vapor deposition chamber comprises a plasma enhanced chemical vapor deposition chamber.

15. The system of claim 11, wherein each of the carbon etch chamber and the dielectric etch chamber comprises a reactive ion etch chamber.
